# EUROPEAN PATENT APPLICATION

(11) **EP 1 739 836 A1**
(43) Date of publication of application: **03.01.2007**
(21) Application number: 05425453.7
(22) Date of filing: 22.06.2005
(51) Int. Cl.: H03K 17/28, G08B 21/08

(54) **Delayed activation device for signals to be used in water**

(71) Applicant: L.P.E. s.r.l., 03013 Ferentino (IT)
(72) Inventor: Latini, Bruno, 03012 Anagni (FR) (IT)
(74) Representative: Adorno, Silvano

(57) **Abstract**

A low-cost device is described for the activation of signals of various type as used in the sea or fresh water, which is fed by long storage life batteries feeding an activation circuit only upon a contolled period of immersion in water. The device comprises a feed accumulator (1) formed of said batteries, commonly separated from the delay and activation circuits by means of a switch (2) which can be operated in fresh water or sea water, an electronic delay circuit (3) and an electric power accumulation (4), a threshold circuit (5) for a fine regulation of the activation delay, a final power stage (6) and a possible short-circuit system (7) immediately before the signal activator.

## Description

The present invention relates to an electronic device for triggering signals of any type, such as based on light and/or smoke, radio emissions, sonic and ultrasonic emissions, both of the continuous and impulsive type, being used for signaling in the water (either sea water or fresh water), in particular when asking for assistance and for exchanging communications of various nature between two shippings or from a shipping to aircrafts.

The devices for triggering signals of this type, which are presently known and can be normally used, are fed by batteries which can be activated by sea water. However such devices show several drawbacks or limitation, mainly due to the fact that the batteries activable by sea water:
- can obviously be used only for the activation of signals immersed in salt water and hence, when used in fresh water, need a certain quantity of sea salt to be introduced in the battery holder before its deposition in water;
- are very expensive and must be stocked in big quantities to limit their costs to non-prohibitive levels, with consequent financial tying up and substantial economical investments strongly effecting the final costs of the activating device in which the batteries are used;
- have only few minutes of life after being activated, whereby the signals can be repeated in a restricted lapse of time;
- as "one-shock" devices are involved, the batteries cannot undergo a unitary final testing which could be necessary for certain types of signals, and finally
- are made by a very restricted number of manufacturers, thus resulting of difficult supplying.

Therefore it is an object of the present invention to provide an electronic actuator device that overcomes the above-mentioned drawbacks and limitations, while being of low cost and simple manufacturing due to the fact of using feed batteries showing a very long time of preservation, i.e. more than ten years of storage. Furthermore these batteries can be found at the usual channels of acquisition, being available also at retailers, having anyhow an extremely reduced cost. The use of said batteries is made possible by connection in a circuit through a water-activable switch being formed, in its preferred embodiment, of a simple connecting device comprising two metallic members facing to each other which provide, in stored conditions, an open circuit having in practice infmite impedance and which, upon immersion in water, regardless whether fresh or salt water, show a low closure resistance, thus allowing the circuit to be fed and consequently the trigger to operate.

The circuit thus manufactured allows a unitary and repeatable operating control; in addition, after long periods of storage, a unitary functional control is again allowed without any limitation of the characteristics of use with clear advantages of economy, safety and reliability.

The objects of the present invention are achieved by means of an electronic device the main features of which are specified in claim 1, whereas particular aspects and preferred embodiments are defined in the claims depending thereon.

These and other objects, advantages and features of the device according to the present invention will be clearer from the following detailed description given by way of non-limiting example with reference to the annexed drawings in which:
Figure 1 is a block diagram of the complete electronic device;
Figure 2 is an overall view, partially in cross-section, of a preferred embodiment thereof, i.e. of the type suitable to be launched by an aircraft; and
Figure 3 is a schematic representation of the electronic circuit of the actuator in a possible embodiment thereof.

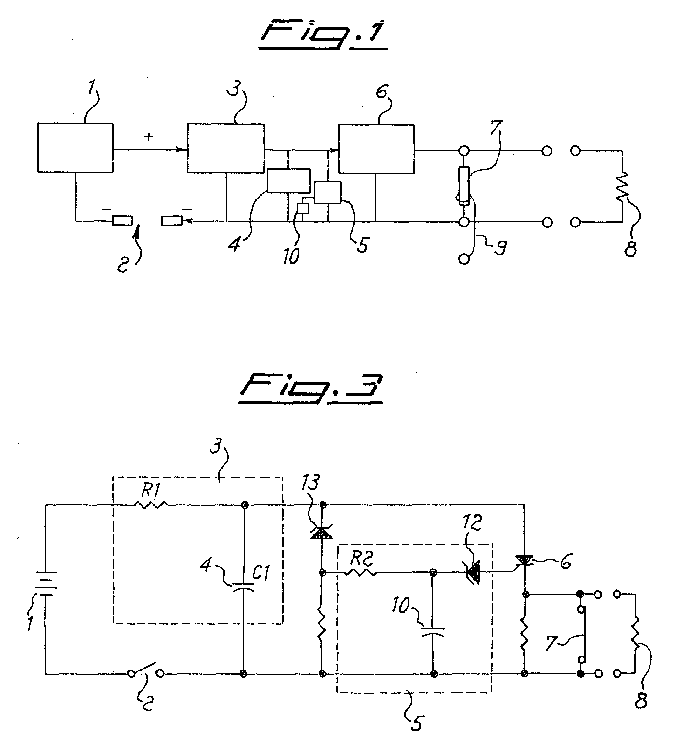

With reference to the drawings, in particular to Fig. 1, the device according to the invention comprises a feed battery 1 suitable for a long store life, directly connected to the circuit on its positive pole and connected to the negative pole of the circuit through a switch 2 which can be actuated by immersion in water, preferably being comprised of two metal members or electrodes, placed at a gauged distance from each other.

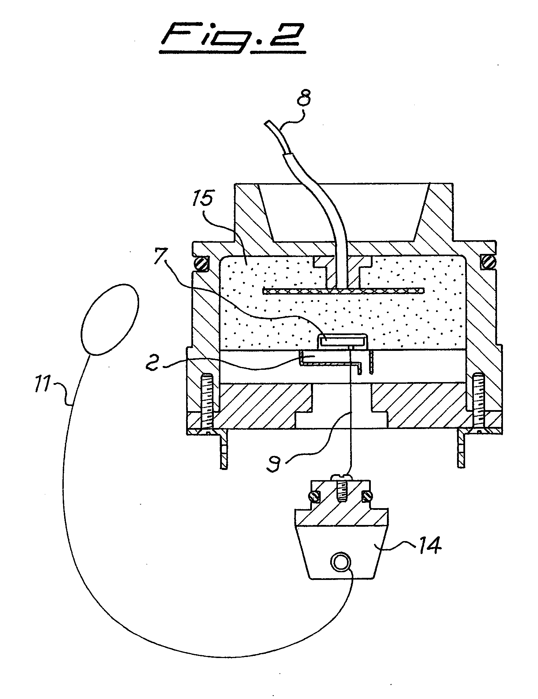

The shape and the mutual distance of the two electrodes allow for a first determination of the time of delay in activating the device because, through an appropriate choice of these parameters, it is possible to vary, within sufficiently broad limits, the equivalent resistance of connection between the two electrodes, consisting in the intermediate water layer. Furthermore the circuit comprises between said switch 2 and a signal actuator 8, an electronic circuit 3 of activation delay with electric power accumulator 4. Such an electronic circuit comprises identical components, although logically separated as to the function, a threshold circuit 5 also adapted for finely adjusting the delay with relevant accumulator 10 and a final power or actuation stage 6, whose consent to the operation is given by said circuit 5 only upon exceeding, with a further controlled delay, a pre-set threshold such as a Zener diode 12 (Fig. 3).

Similarly a Zener diode 13 determines the threshold value for the delay imparted by the circuit 3. Before the actuating circuit 8 there is preferably provided a short-circuit element 7 having the purpose of preventing said circuit 8 from triggering under storage conditions, which is instead allowed only upon its removal. Therefore the short-circuit element 7 acts as a transportation and handling safety for an actuator 8 than can consist of either an electric igniter or a pyric or electro-mechanical actuation of any type, capable of being operated by the discharge of a capacitor being outside of the device according to the invention and connectable thereto by means of suitable electric wires.

With reference to Fig. 3, it will be noted that the power accumulator 4, that in the logical diagram of Fig. 1 has been represented separately from the circuit 3, is indicated as a part thereof, consisting in practice of a capacity of suitable value C1, coupled to a resistor R1 for generating the delay and capable of providing, upon crossing the said threshold 13, the electric power required for triggering the actuator 8 through the additional threshold 5 in view of the final activation. The assembly formed of capacitor 4 and resistor R1 is shown enclosed by a dotted line schematically representing the circuit 3, comprising also the Zener diode 13.

As stated above, still with reference to Fig. 3, to the threshold circuit 5 for finely controlling the delay is associated a Zener diode 12 or possibly other electronic devices having the same function, i.e. that of allowing the operation of the final stage 6 of activation only upon exceeding a determined voltage value of a capacitor 10.

The short-circuit element 7 has been schematically represented in Fig. 3 has consisting in a simple short circuit with pre-established breaking limit or, as shown in Fig. 2 for that embodiment of device, by means of a simple jumper connection which can be withdrawn by means of a suitable removal strap 9 schematically represented also in Fig. 1.

In view of the above and with particular reference to the embodiment of Fig. 2, the operation of the device can be described as follows.

Before laying the device of the invention in water, the short circuit 7 is withdrawn, such as by means of the strap 9 connected therewith, which is subjected to a sufficient drawing force to remove the same. The strap 9 is also connected to a tension and protection plug 14 which is in turn connected through another cord 11 to the stationary portion of a dispenser on board e.g. of an aircraft, thus providing for withdrawal of the short circuit 7 upon releasing the signal 8 as a consequence of the drawing action exerted by the weight of the signal itself.

In Fig. 2 there is illustrated a block of epoxidic resin 15 in which the electronic circuits 3-6 and the power source 1 are embedded, whereas the element 8 represents the wires of electric connection to the actuator having the same reference numeral in Figs. 2 and 3.

As soon as the device touches the water, a low-resistance connection is established between the electrodes of switch 2, whereby the battery 1 starts supplying electric power while charging capacitor 4. Charging occurs with a time constant determined by the value of capacity and resistance in series on the charge circuit. Consequently, only upon an established delay, required for allowing the activator to settle its position in the water, the capacitor voltage exceeds the threshold of Zener diode 13 and can thereby start charging the second circuit 5 for finely controlling the delay, in particular capacitor 10 with resistor in series R2. The voltage between the poles of said capacitor increases up to exceeding the threshold of Zener diode 12, thus triggering the final circuit 6. The associate switch I1 (of the electronic or electro mechanical type, e.g. a relay), represented in Fig. 3 of the SCR type, becomes closed, thus allowing the accumulated power to discharge through actuator 8 and enabling the signal triggering.

## Claims

1. Delayed activation device for signals, to be used in the sea or fresh water, **characterized by** comprising a long storage life feed battery (1), of commercial type, being kept isolated by the other components of the device by means of a switch (2) activable by immersion in water; a first circuit (3) of determined delay, integrated with a power accumulation circuit (4); a second threshold and delay circuit (5) for finely controlling the activation delay, adapted to be fed by the accumulation circuit (4) after the first delay given by said first circuit (3) to reach such a voltage level as to exceed a threshold introduced in said circuit (5) and establish the actuation of a final power stage or electronic switch (6) for discharging the power of accumulation circuit (4) into the activator (8), thus determining the signal actuation.

2. A device according to claim 1, **characterized in that** the feed switch (2) consists in two metal members facing to each other which allow a limited electric current flow charging the first electronic circuit of delay (3) and the power accumulation circuit (4) upon immersion in fresh water or sea water.

3. A device according to claim 1 or 2, **characterized in that** said power accumulation circuit (4), associated with a resistor in series (R1), consists in a capacitor adapted to be charged, upon closing said switch (2) up to a voltage exceeding a pre-set value of threshold, which is determined by said first delay circuit (3).

4. A device according to claim 3, **characterized in that** said second delay and threshold circuit (5) for a fine regulation of the overall delay comprises a capacitor (10) and a resistor (R2) to be charged at increasing voltage until exceeding a controlled threshold value for triggering said final power stage (6).

5. A device according to claim 1, **characterized in that** said final power stage (6) substantially consists in an electronic or electromechanical switch capable of closing the connection between the power accumulation circuit (4) and the final activator (8) for the actuation of the latter.

6. A device according to one or more of the preceding claims,
**characterized by** further comprising a short-circuit element (7) formed as a jumper connection that can be withdrawn or the breaking thereof can be pre-established, being connected to a removal cord (9) for preventing power from being transferred from circuit (4) to the activator during its transportation and handling steps.

7. A device according to claim 3, wherein said threshold value for determining said first controlled delay is obtained by means of a Zener diode (13) provided in said delay circuit (3).

8. A device according to claim 1, wherein said threshold value for determining said second finely adjustable delay for activating the final power stage (6) is obtained by means of a Zener diode (12) provided in said threshold circuit (5).
